# EUROPEAN PATENT APPLICATION

(11) **EP 4 819 793 A1**
(43) Date of publication of application: **07.10.2026**
(21) Application number: 25181223.6
(22) Date of filing: 06.06.2025
(51) Int. Cl.: H10D 30/66, H10D 62/85, H10W 42/00

(54) **SEAL RING STRUCTURE**

(30) Priority: 04.04.2025 US 202519170614
(71) Applicant: GlobalFoundries U.S. Inc., Malta, NY 12020 (US)
(72) Inventor: LEVY, Mark David, Essex Junction, VT 05452 (US); BROWN, Brennan Jackson, Essex Junction, VT 05452 (US)
(74) Representative: Lambacher, Michael

(57) **Abstract**

The present disclosure relates to semiconductor structures and, more particularly, to seal ring structures and methods of manufacture. The structure includes: a trench structure in a GaN stack of material; an ohmic metal contacting an upper surface of the GaN stack of material on a side of the trench structure; and a seal ring structure vertically extending from and in contact with the ohmic metal, on a side of the trench structure.

## Description

This invention was made with government support under contract HQ0727790700 awarded by Defense Microelectronics Agency (DMEA). The government has certain rights in the invention.

### BACKGROUND

The present disclosure relates to semiconductor structures and, more particularly, to seal ring structures and methods of manufacture.

MOSFET devices are used in power switches in power applications, amongst other applications. MOSFET devices continue to improve in key parameters, e.g., on-resistance, voltage ratings, switching speed, etc. However, performance of MOSFET devices may be coming close to their physical limitations.

To continue with improvements, GaN devices have become attractive in many applications. GaN devices are high electron mobility transistor (HEMT) devices. GaN devices may have a higher electric-field strength than conventional MOSFETS, providing further performance improvements in, for example, on-resistance and breakdown voltage while offering fast switching speed amongst other important parameters. GaN devices, though, are susceptible to moisture penetration, which may affect device performance and integrity.

### SUMMARY

In an aspect of the disclosure, a structure comprises: a trench structure in a GaN stack of material; an ohmic metal contacting an upper surface of the GaN stack of material on a side of the trench structure; and a seal ring structure vertically extending from and in contact with the ohmic metal, on a side of the trench structure.

The structure may further comprise a barrier material over the GaN stack of material; the ohmic metal may extend through the barrier material and contact the GaN stack of material.

The trench structure may extend through the GaN stack of material to an underlying semiconductor substrate. Further, the trench structure may comprise a lining of a first insulator material and a second insulator material filling remaining portions of the trench structure; the first insulator material may comprise nitride and the second insulator material may comprise an interlevel dielectric material. Optionally, the structure may further comprise a third insulator material lining a surface of the second insulator material and underneath the ohmic metal.

Further, the ohmic metal may be a continuous ohmic metal that extends over the trench structure and on opposing sides of the trench structure.

Further, the seal ring structure may connect to the ohmic metal on an outer edge of the trench structure, opposing from an active region; optionally, the seal ring structure may completely surround the active region. Further, the seal ring structure may comprise metal materials; alternatively, the seal ring structure may comprise via interconnects and wiring structures.

In an aspect of the disclosure, a structure comprises: a trench structure in a GaN stack of material which extends to an underlying semiconductor material; an ohmic metal contacting an upper surface of the GaN stack of material and surrounding the trench structure; an active region adjacent an inner side of the trench structure; and a seal ring structure vertically extending from and encapsulated by the ohmic metal.

The structure may further comprise a barrier material over the GaN stack of material; the ohmic metal may extend through the barrier material and contact the GaN stack of material.

Further, the trench structure may comprise a lining of a first insulator material and a second insulator material filling remaining portions of the trench structure; optionally, the structure may further comprise a third insulator material lining a surface of the second insulator material.

Further, the seal ring structure may connect to the ohmic metal on the outer side of the trench structure, opposing the active region; optionally, the seal ring structure may completely surround the active region.

Further, the seal ring structure may comprise conductive materials. Alternatively, the seal ring structure may comprise via interconnects and wiring structures extending through an interlevel dielectric material.

In an aspect of the disclosure, a method comprises: forming a trench structure in a GaN stack of material; forming an ohmic metal contacting an upper surface of the GaN stack of material on a side of the trench structure; and forming a seal ring structure vertically extending from and in contact with the ohmic metal, on a side of the trench structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a seal ring structure and respective fabrication processes in accordance with aspects of the present disclosure.
FIG. 2 shows a top view of the structure in accordance with aspects of the present disclosure.
FIG. 3 shows fabrication processes for manufacturing the structure of FIG. 1 in accordance with aspects of the present disclosure.

### DETAILED DESCRIPTION

The present disclosure relates to semiconductor structures and, more particularly, to a seal ring structure and methods of manufacture. More specifically, the present disclosure relates to a seal ring structure for GaN devices. Advantageously, the seal ring structure prevents moisture ingress into a GaN layer and an active region of a high electron mobility transistor (HEMT).

In more specific embodiments, a III-V device comprises a semiconductor substrate, a channel layer (e.g., GaN) above the semiconductor substrate and a moisture barrier layer within a trench in the channel layer. In embodiments, the trench may be a seal ring trench. The trench may extend entirely through the channel layer at an edge of the active region. In further embodiments, the ohmic metal contact may be a continuous ohmic metal contact connected to the GaN layer on opposing sides of the trench. A seal ring structure may be provided over and in direct contact with the ohmic metal contact adjacent to the trench thereby preventing ingress of moisture into the active region. In embodiments, the ohmic metal covers the trench and contacts the GaN on either side of the trench, so no moisture can "jump the gap" through the interlevel dielectric layers.

The seal ring structures of the present disclosure can be manufactured in a number of ways using a number of different tools. In general, though, the methodologies and tools are used to form structures with dimensions in the micrometer and nanometer scale. The methodologies, i.e., technologies, employed to manufacture the seal ring structures of the present disclosure have been adopted from integrated circuit (IC) technology. For example, the structures are built on wafers and are realized in films of material patterned by photolithographic processes on the top of a wafer. In particular, the fabrication of the seal ring structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

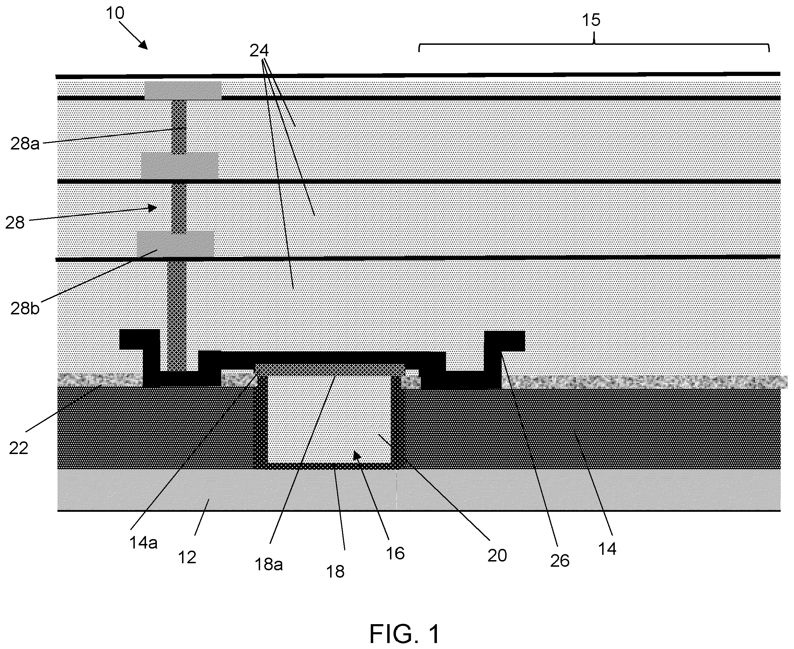

FIG. 1 shows a seal ring structure, amongst other features, and respective fabrication processes in accordance with aspects of the present disclosure. More specifically, the structure 10 of FIG. 1 includes GaN material 14, e.g., stack of GaN material, provided on a semiconductor substrate 12. In embodiments, the semiconductor substrate 12 may be any appropriate substrate material used in a III-V device including, but not limited to, Si, SiC or Sapphire, as examples.

The GaN stack 14 may comprise a channel layer for a HEMT or metal insulator silicon HEMT (MISHEMT), and may be defined by different layers including, but not limited to, a buffer layer on the semiconductor substrate 12, e.g., AlN, a GaN layer on top of the buffer layer and a top layer of AlGaN. It should be understood by those of ordinary skill in the art that other materials may be used in the stack of materials, and that the above example is merely an illustrative, non-limiting example. For example, the GaN layer may include different percentage concentrations of Ga as this layer transitions from an upper surface to a lower surface. Also, in preferred embodiments, the semiconductor substrate 12 and the GaN stack 14 may include different bandgaps. The patterning of the GaN stack 14 may result in a slight stepped structure 14a at an edge of a trench 16. It should be recognized by those of skill in the art that the present disclosure is not limited to a GaN stack 14 and, in embodiments, may be other transistors comprising different III-V materials such as GaAs and AlGaAs (as a substitute for GaN and AlGaN).

Still referring to FIG. 1, a barrier layer 22, e.g., aluminum oxide, may be formed over the over the GaN stack 14. In embodiments, the trench 16 may be formed through the GaN stack 14 and the barrier layer 22, on an outer edge of an active region 15. In embodiments, the trench 16 may extend to the semiconductor substrate 12. In embodiments, it is also contemplated to deposit this Al₂O₃ after trench formation. The PGAN gate material (if any) can be patterned before the deposition of the Al₂O₃. The trench 16 may be lined with a moisture barrier layer 18 on all sides and a bottom surface. The moisture barrier layer 18 may be SiN or another non-conductive material. The trench 16 may be filled with an insulator material 20 such as oxide material or other low-k dielectric material 20. In embodiments, the insulator material 20 may be interlevel dielectric material.

An optional moisture barrier layer 18a may be provided over the insulator material 20 (and under metal material 26, e.g., ohmic contacts). The optional moisture barrier layer 18a may be a single layer or a stack of layers, e.g., nitride and oxide, and may be patterned over the insulator material 20 and extend to either the GaN stack 14, barrier layer 22 or the barrier layer 18. As should be understood by those of ordinary skill in the art, the moisture barrier layers 18, 18a prevent moisture ingress into the active region 15 of the GaN stack 14 from both an upper surface and an outer edge. In embodiments, the barrier layer 18a may be used to protect a seam, if any, from any subsequent etches or wet cleans of dielectric materials.

Still referring FIG. 1, a metal material 26 may be formed in contact with the GaN material 14, e.g., stack of GaN material. In further embodiments, the metal material 26 covers the trench and contacts the GaN stack 14 on either side of the trench 16, so no moisture can "jump the gap" through the interlevel dielectric layers. The metal material may contact an upper surface of the optional moisture barrier layer 18a and may encapsulate the trench 16, itself. In embodiments, the metal material 26 may be an ohmic contact. The metal material 26 may be formed directly on, e.g., contacting, an upper surface of the GaN stack 14, extending through an opening in the barrier layer 22. In embodiments, the metal material 26 may extend over the trench 16 and contact the GaN stack 14 on either side of the trench 16 and, preferably, on an opposing side to the active region 15. In embodiments, the metal material 26 does not need to contact the device active region, as it may be preferential to ground the guarding independently of the device elements. The metal material 26 may aluminum, an aluminum base material, WN, TiN, or TaN, tungsten, or combinations thereof, etc. Several layers of insulator material 24 may be provided above the metal material 26 and barrier material 22. The insulator material 24 may include alternating layers of oxide and nitride, as an example.

FIG. 1 further shows a seal ring structure 28 extending to the metal material 26 on a side of the trench 16 and on an opposing side of the active region 15. In embodiments, the seal ring structure 28 directly contacts the metal material 26 and extends to an upper surface of a top insulator layer 24, e.g., interlevel dielectric material. In more specific embodiments, the seal ring structure 28 is a vertical structure with continuous metal all the way up to last metal wiring layer. As should be understood by those of skill in the art, the seal ring structure 28 is a continuous ring around the chip, e.g., active region 15.

As an example, the seal ring structure 28 may include a combination of interconnect structures 28a and wiring structures 28b (connecting together to form a monolithic vertical structure extending from the metal material 26 to an upper surface of the insulator material 24). The interconnect structures 28a may be tungsten; although other materials are also contemplated herein such as copper or cobalt, as examples. The wiring structures 28b may include copper or aluminum as non-limiting examples.

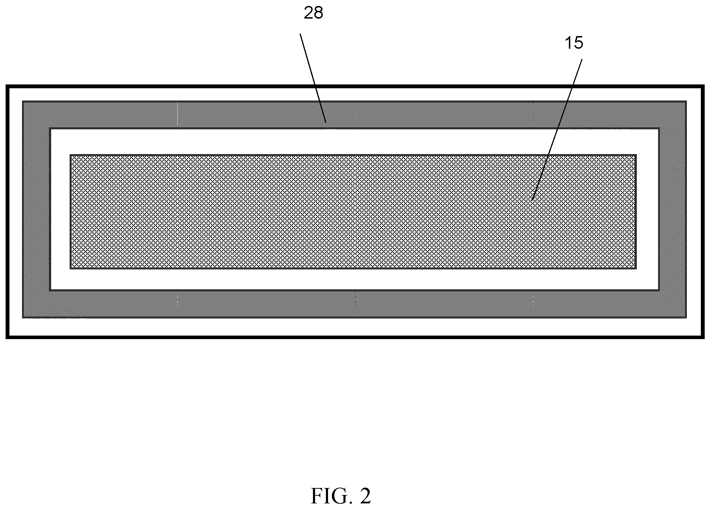

FIG. 2 shows a top view of the structure in accordance with aspects of the present disclosure. In embodiments, the seal ring structure 28 completely surrounds the active region 15 of the device. In embodiments, the active region 15 may include the gate structure and related channel region as is known in the art such that no further explanation is required for a complete understanding of the present disclosure.

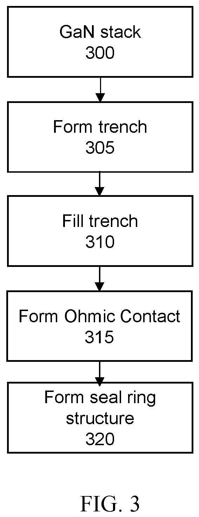

FIG. 3 shows fabrication processes for manufacturing the structure of FIG. 1 in accordance with aspects of the present disclosure. At step 300, a GaN stack (including the barrier layer) may be deposited on a semiconductor substrate. In embodiments, the GaN stack may be formed by an epitaxial growth (MOCVD or MBE) to ensure (more or less) single crystal GaN/AlGaN. The initial AlN deposition can be in the same process or via CVD/PVD.

At step 305, a trench may be formed through the GaN stack to the underlying semiconductor substrate using conventional lithography and etching processes. For example, a resist formed over the GaN stack and barrier layer is exposed to energy (light) and developed utilizing a conventional resist developer to form a pattern (opening). An etching process with a selective chemistry, e.g., reactive ion etching (RIE), will be used to transfer the pattern from the photoresist layer to form one or more trenches in the GaN stack and barrier layer through the openings of the resist.

Following the resist removal by a conventional oxygen ashing process or other known stripants, at step 310, the trench may be filled. For example, a nitride layer may be deposited to line the trench followed by an oxide material to fill the trench. The nitride layer and oxide layer may be deposited by any conventional deposition processes, e.g., CVD processes. An optional nitride layer can be formed over the oxide layer. The deposition processes may be a conventional CVD process. Any residual material on the surface of the GaN stack and barrier layer can be removed by conventional chemical mechanical polishing (CMP) processes.

At step 315, a metal material can be deposited over the trench and the GaN stack 14. In embodiments, the metal material may be any appropriate conductive material that is used for an ohmic contact. As step 320, the metal material is patterned using conventional lithography and etching processes to form a contact over and on opposing sides of the trench.

As step 320, back end of the line processes are used for form the seal ring structure. In embodiments, the seal ring structure is formed by conventional back end of the line processes. For example, an interlevel dielectric material may be deposited over the metal material (e.g., ohmic contact), followed by a lithography and etching process to form of a trench which exposes the metal material (outside of the active region). In embodiments, the lithography and etching process may be a single or dual damascene process. In any scenario an interconnect metal and a wiring metal are formed within the trenches in consecutive wiring layers as is known to those of skill in the art such that no further explanation is required for a complete understanding of the present disclosure. Following deposition processes for each wiring layer, the materials can be subjected to a planarization process (e.g., chemical mechanical process) to prepare the surface for deposition of additional materials in the next wiring level as should be understood by those of skill in the art.

The seal ring structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a trench structure in a GaN stack of material;
an ohmic metal contacting an upper surface of the GaN stack of material on a side of the trench structure; and
a seal ring structure vertically extending from and in contact with the ohmic metal, on a side of the trench structure.

2. The structure of claim 1, wherein the trench structure extends through the GaN stack of material to an underlying semiconductor substrate.

3. The structure of claim 1 or claim 2, further comprising a barrier material over the GaN stack of material and wherein the ohmic metal extends through the barrier material and contacts the GaN stack of material.

4. The structure of one of claims 1 to 3, wherein the trench structure comprising a lining of a first insulator material and a second insulator material filling remaining portions of the trench structure, wherein, optionally, the first insulator material comprises nitride and the second insulator material comprises an interlevel dielectric material.

5. The structure of claim 4, further comprising a third insulator material lining a surface of the second insulator material and underneath the ohmic metal.

6. The structure of one of claims 1 to 5, wherein the ohmic metal is a continuous ohmic metal that extends over the trench structure and on opposing sides of the trench structure.

7. The structure of one of claims 1 to 6, wherein the seal ring structure connects to the ohmic metal on an outer edge of the trench structure, opposing from an active region, and, optionally, wherein the seal ring structure completely surrounds the active region.

8. The structure of claim 7, wherein the seal ring structure comprises metal materials, and/or wherein the seal ring structure comprises via interconnects and wiring structures.

9. A structure comprising:
a trench structure in a GaN stack of material which extends to an underlying semiconductor material;
an ohmic metal contacting an upper surface of the GaN stack of material and surrounding the trench structure;
an active region adjacent an inner side of the trench structure; and
a seal ring structure vertically extending from and encapsulated by the ohmic metal on an outer side of the trench structure.

10. The structure of claim 9, further comprising a barrier material over the GaN stack of material and wherein the ohmic metal extends through the barrier material and contacts the GaN stack of material.

11. The structure of claim 9 or claim 10, wherein the trench structure comprising a lining of a first insulator material and a second insulator material filling remaining portions of the trench structure, and, optionally, wherein the structure further comprises a third insulator material lining a surface of the second insulator material.

12. The structure of one of claims 9 to 11, wherein the seal ring structure connects to the ohmic metal on the outer side of the trench structure, opposing the active region, and, optionally, wherein the seal ring structure completely surrounds the active region.

13. The structure of one of claims 9 to 12, wherein the seal ring structure comprises conductive materials.

14. The structure of one of claims 9 to 12, wherein the seal ring structure comprises via interconnects and wiring structures extending through an interlevel dielectric material.

15. A method comprising:
forming a trench structure in a GaN stack of material;
forming an ohmic metal contacting an upper surface of the GaN stack of material on a side of the trench structure; and
forming a seal ring structure vertically extending from and in contact with the ohmic metal, on a side of the trench structure.
